Europäisches Patentamt

**European Patent Office**

Office européen des brevets

(19)

(11) Numéro de publication: **0 109 867**
**B1**

(12) **FASCICULE DE BREVET EUROPEEN**

(45) Date de publication du fascicule du brevet:
09.04.86

(51) Int. Cl.⁴: **G 01 R 33/028**

(21) Numéro de dépôt: 83401944.0

(22) Date de dépôt: 04.10.83

(54) Dispositif capteur de champ magnétique alternatif à haute sensibilité, et à large bande, et appareil de mesure l'utilisant.

(30) Priorité: 15.10.82 FR 8217296

(43) Date de publication de la demande:
30.05.84 Bulletin 84/22

(45) Mention de la délivrance du brevet:
09.04.86 Bulletin 86/15

(84) Etats contractants désignés:
BE CH DE GB IT LI SE

(56) Documents cités:
NL - A - 6 701 915

IEEE TRANSACTIONS ON ELECTROMAGNETIC COMPATIBILITY, vol. EMC-16, no. 2, mai 1974, New York (US) P.H. DUNCAN: "Analysis of the Moebius loop magnetic field sensor", pages 83-89
IEEE TRANSACTIONS ON INSTRUMENTATION AND MEASUREMENT, vol. IM-29, no. 4, décembre 1980, New York (US) I. YOKOSHIMA et al.: "HF magnetic field standard", pages 451-454

(73) Titulaire: **THOMSON-CSF, 173, Boulevard Haussmann, F-75379 Paris Cedex 08 (FR)**

(72) Inventeur: **Levan, Jean-Pol, THOMSON-CSF SCPI 173, bld Haussmann, F-75379 Paris Cedex 08 (FR)**
Inventeur: **Eumurian, Grégoire, THOMSON-CSF SCPI 173, bld Haussmann, F-75379 Paris Cedex 08 (FR)**

(74) Mandataire: **Trocellier, Roger et al, THOMSON-CSF SCPI 19, avenue de Messine, F-75008 Paris (FR)**

LIBER, STOCKHOLM 1986

## Description

La présente invention concerne un dispositif capteur de champ magnétique alternatif, à haute sensibilité et à large bande permettant de réaliser un appareil de mesure performant.

Le développement des transmissions électromagnétiques a entraîné un élargissement des fréquences tant du côté des fréquences basses (quelques 10 Hz pour les transmissions sous-marines), que des fréquences élevées (plusieurs dizaines de gigahertz pour les transmissions par satellites).

La plupart des capteurs de champ magnétique ne couvrent chacun qu'une gamme de fréquence réduite, quelques octaves dans le meilleurs des cas.

On voit donc l'intérêt d'un capteur à très large bande permettant d'une part de remplacer plusieurs capteurs à bande étroite et, d'autre part, de saisir un phénomène dont le spectre instantané de fréquence est très étendu. Ce type de capteur autorise également l'étude de phénomènes transitoires (parasites, perturbations atmosphériques, foudroiements etc.) dont le spectre de fréquence n'est pas toujours connu a priori, d'où la nécessité de chercher le phénomène dans la bande passante la plus large possible.

Les mesures de champ magnétique H peuvent se faire avec des capteurs utilisant plusieurs techniques dont l'effet Hall et l'induction d'une tension dans un conducteur selon la loi de Lorenz.

Les senseurs à effet Hall sont limités en fréquence à quelques mégahertz. Par contre la limitation en fréquence des senseurs utilisant l'induction magnétique ne vient que de la constitution et de la géométrie du capteur.

La tension induite dans un bobinage est proportionnelle à la fréquence du phénomène, à la section totale du bobinage et au nombre de spires. Pour obtenir une bonne sensibilité aux fréquences basses, il est donc nécessaire d'augmenter la section ainsi que le nombre de spires. Par contre, pour élargir la réponse aux fréquences élevées il faut que le bobinage ait de faibles capacités parasites et donc un nombre de spires réduit, et que les dimensions du capteur soient faibles devant la longueur d'onde correspondant à la fréquence la plus élevée. Par ailleurs, pour obtenir une bonne réjection du champ électrique E, le bobinage doit être blindé ce qui augmente les capacités parasites et limite d'autant la réponse en fréquence.

Il s'avère par suite difficile de réaliser un capteur ayant une large bande passante et une bonne sensibilité aux fréquences basses.

Le cadre blindé est une solution connue qui se présente sous la forme d'une bobine plate blindée. Le blindage est fendu afin qu'il ne constitue pas une boucle en court-circuit qui absorberait la quasi-totalité du champ magnétique par courants de Foucault induits. Un tel dispositif capteur de champ magnétique peut être optimisé soit pour une bonne sensibilité aux fréquences basses (grand diamètre, grand nombre de spires), soit pour une réponse aux fréquences élevées (faible diamètre, faible nombre de spires). La première optimisation conduit à une mauvaise réponse aux fréquences élevées (fréquence de résonance trop basse), la deuxième optimisation entraîne une limitation de la sensibilité aux fréquences basses (section totale du bobinage trop réduite).

La boucle de Moebius est une autre solution connue qui est constituée de deux demi-boucles réalisées avec du câble coaxial, montées en série en connectant le conducteur central de l'une avec la gaine de l'autre et vice versa, voir par exemple l'article para dans IEEE TRANSACTIONS ON ELECTROMAGNETIC COMPATIBILITY, vol EMC—16, n° 2, en mai 1974 à New York (USA), par P. H. DUNCAN et intitulé: "Analysis of the Moebius loop magnetic field sensor" aux pages 83—89. Ce montage présente une réponse aux fréquences élevées beaucoup plus étendue que celle d'un cadre blindé classique. La structure étant coaxiale et adaptée en sortie, la limitation aux fréquences élevées n'apparaît pas tant que la longueur d'onde reste nettement plus grande que le diamètre. La sensibilité aux fréquences basses correspond à celle d'un cadre de mêmes dimensions et comportant deux spires, donc faible.

Aucun de ces deux dispositifs connus ne permet donc d'obtenir à la fois une réponse en fréquence étendue et une bonne sensibilité aux fréquences basses.

Le but de l'invention est de remédier aux inconvénients et limitations des solutions précitées tout en procurant un capteur plus performant par le fait qu'il en cumule les avantages.

Le dispositif capteur proposé est constitué d'un bobinage effectué à l'aide d'une ligne (coaxial, strip line ou ligne à ruban, etc.) dont l'impédance caractéristique est constante et connue, à chaque spire le conducteur extérieur formant blindage est interrompu pour éviter de créer des boucles en court-circuit. L'effet de la rupture d'impédance due à chacune de ces coupures de conducteur extérieur est compensé par une adaptation correspondante obtenue par le branchement entre les conducteurs internes et externes d'un réseau correspondant à l'impédance caractéristique de la ligne utilisée pour le bobinage. La sensibilité au champ électrique due à l'interruption périodique de blindage est réduite par un blindage supplémentaire localisé au niveau de chaque coupure. La sortie de la bobine se fait en différentiel avec adaptation d'impédance aux deux extrémités. En outre, pour augmenter la sensibilité de ce dispositif capteur tout en gardant des dimensions réduites, un noyau magnétique peut être placé à l'intérieur du bobinage.

Selon l'invention telle que revendiquée, il est proposé un dispositif capteur de champ magnétique utilisant une ligne d'impédance caractéristique constante, en structure coaxiale, comportant une spire démunie de son conducteur externe sur une portion de la ligne, et avec des premiers moyens d'adaptation à ladite impédance caractéristique prévus aux extrémités de sortie de la ligne destinées à être raccordée à un appareil de mesure du courant induit, le dispositif capteur étant caractérisé par le fait que la ligne se compose d'une pluralité de spires formant un bobinage dont chaque spire comporte également une portion démunie du conducteur extérieur et chacune de ces portions étant dotée de second moyens d'adaptation pour compenser la rupture d'adaptation créée par ces interruptions de ligne coaxiale.

Les particularités et avantages de la présente invention apparaîtront dans la description qui suit donné à titre d'exemple non limitatif à l'aide des figures annexées qui représentent:

— Fig. 1, un dispositif capteur selon l'invention réalisé en ligne coaxiale;

— Fig. 2, un détail du montage de la Fig. 1 montrant des éléments d'adaptation et la possibilité de blindage;

— Fig. 3 à Fig. 5, des variantes de réalisation des adaptations aux interruptions de ligne;

— Fig. 6, un dispositif capteur conforme à l'invention, réalisé en circuit imprimé souple;

— Fig. 7, une partie de la structure développée du circuit imprimé selon la Fig. 6;

— Fig. 8, un dispositif capteur conforme à l'invention réalisé en circuit imprimé sur une structure rigide;

— Fig. 9, un détail de la réalisation selon Fig. 8 montrant la mise en place d'éléments d'adaptation.

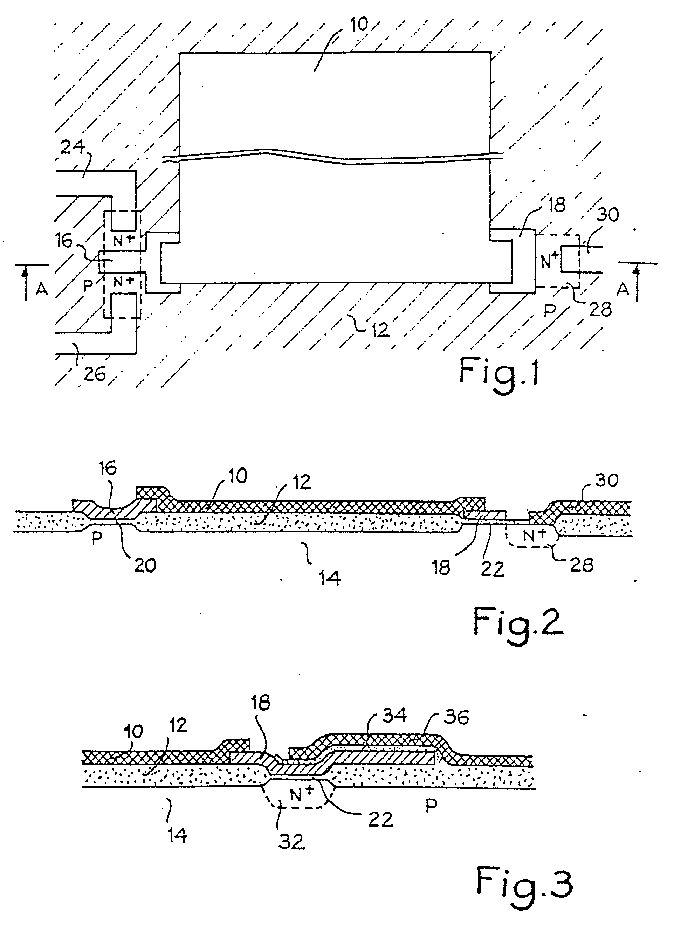

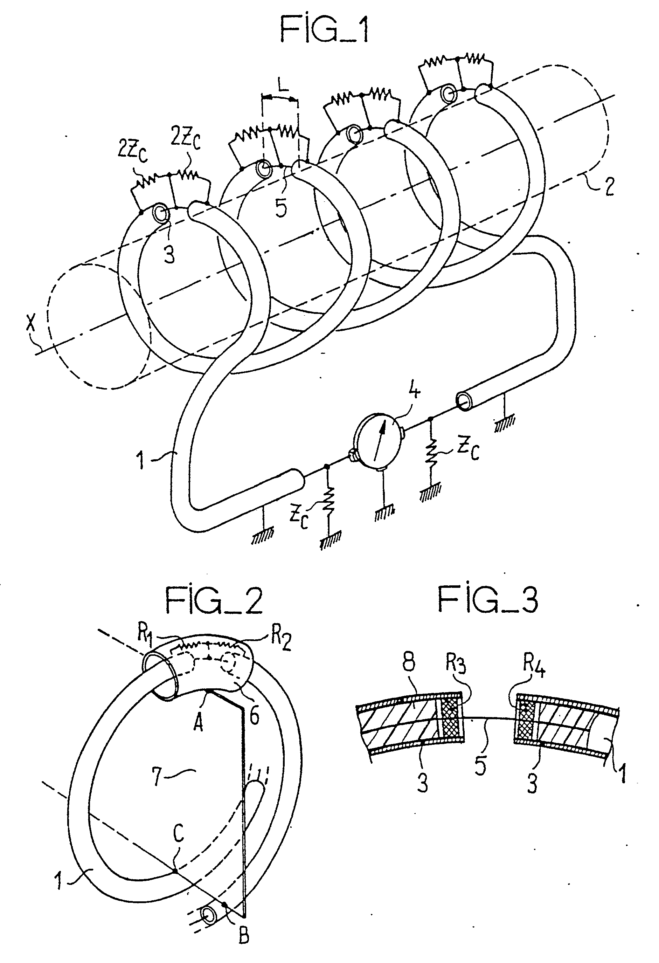

En se reportant à la Fig. 1, le dispositif capteur est réalisé avec une ligne d'impédance caractéristique constante en câble coaxial qui peut être souple, semi-rigide ou rigide. Cette ligne comporte une pluralité de spires et forme un bobinage hélicoïdal. Il peut être obtenu par enroulement du câble 1 sur un mandrin cylindrique 2 comportant ou non un noyau magnétique, selon la sensibilité et la réponse en fréquence désirée. A chaque spire, le conducteur externe 3 du coaxial est interrompu sur une portion de la ligne en sorte d'éviter que le blindage 3 ne forme une spire en court-circuit qui serait le siège de courants de Foucault. Les portions dénudées sont régulièrement situées le long de la ligne à des écartements correspondant à la longueur d'une spire, le bobinage formant une hélice régulière autour d'un cylindre droit et les portions dénudées étant alignées parallèlement à l'axe du cylindre.

Les extrémités de la ligne sont adaptées et connectées à un appareil annexe 4 de mesure de courant alternatif pour mesurer le courant induit par le champ magnétique dans le bobinage capteur. En appelant de manière conventionnelle Zc l'impédance caractéristique de la ligne, cette adaptation peut s'effectuer avec des éléments discrets comme figurés, en général des éléments purement resistifs de valeur Zc. D'autres moyens d'adaptation sont prévus à chaque portion démunie de blindage pour compenser la rupture d'impédance correspondante et préserver l'adaptation de la ligne. Ceci peut s'effectuer avec une ou plusieurs impédances dont la valeur équivalente est égale à l'impédance caractéristique Zc du câble. Dans l'exemple représenté chaque portion comporte deux éléments discrets de valeur 2Zc chacun, reliant respectivement le conducteur central 5 dans cette portion au blindage extérieur 3 à chaque extrémité de câble aboutissant à cette portion.

Pour accroître la rejection du champ électrique, les portions dégagées par interruption du blindage 3, ainsi que les impédances d'adaptation rapportées peuvent être blindées localement.

La Fig. 2 montre une réalisation correspondante à l'endroit d'une zone dégagée de blindage externe 3, les résistances d'adaptation R1 et R2 ont pour valeur 2Zc et sont disposées ainsi que la zone en question à l'intérieur d'un manchon métallique 6. Une plaque ou écran métallique 7 constituant un conducteur à faible impédance est utilisé pour connecter chacun des manchons tel que 6 à la masse, c'est-à-dire au conducteur extérieur 3. Cette connexion ne peut en effet s'effectuer vers la partie dénudée car on reproduirait avec le blindage 6 et le conducteur 3 proche une spire en court-circuit; la connexion est effectuée avantageusement avec le point diamétralement opposé car le plus éloigné du manchon. La plaque 6 est soudée en A au manchon et à l'opposé aux points de soudure B et C avec la gaine extérieure 3 du câble.

La Fig. 3 montre en coupe une variante de réalisation de l'adaptation utilisant des éléments coaxiaux intégrés à la structure de la ligne sous forme de deux résistances coaxiales R3 et R4 chacune de valeur 2Zc. Ces éléments résistifs sont de type connu, et utilisés pour constituer des résistance de charge terminale pour lignes coaxiales.

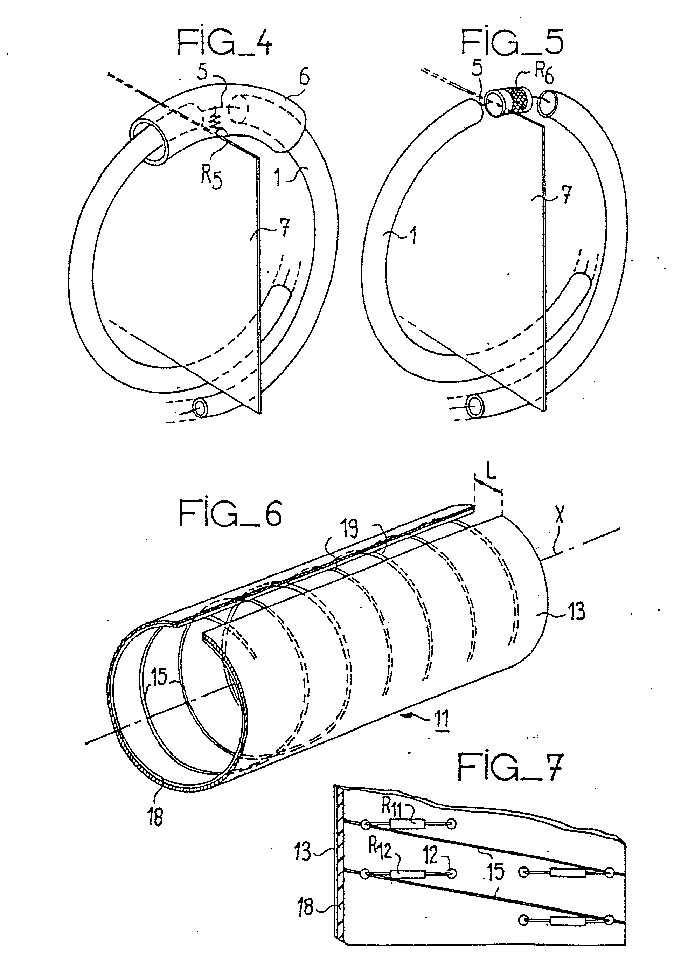

D'autres variantes sont possibles dont deux sont représentées sur la Fig. 4 et la Fig. 5 utilisant un seul élément résistif soit conventionnel R5, soit en structure coaxiale R6; l'élément est connecté entre le conducteur central 5 et la masse, cette dernière connexion s'effectuant par le biais de la plaque métallique 7. L'élément R5 ou R6 a pour valeur Zc.

Dans les montages décrits à plaque médiane 7 si l'on désire placer un noyau en matériau magnétique à l'intérieur du bobinage 1, il sera nécessaire de diviser ce noyau en deux parties disposées de part et d'autre de l'écran 7.

Il n'a pas été question dans ce qui précède de l'isolant 8 (Fig. 3) entre les conducteurs 3 et 5, ce milieu isolant est à ôter car il gênerait pour la soudure de résistances conventionnelles (Figs. 1,2,4), et ne permettrait pas la mise en place de résistance coaxiales (Figs. 3,5).

Il peut être remarqué que le capteur selon l'invention peut tout aussi bien être défini par un pluralité d'éléments de ligne coaxiale connectés bout à bout pour relier leur conducteur central, chaque élément ayant la forme d'une spire et une longueur un peu inférieure à celle d'une spire pour ménager à chaque fois une portion de ligne dénudée du blindage 3.

D'autres modes de réalisation d'un dispositif de champ magnétique conforme à l'invention sont envisageables en utilisant les lignes en ruban obtenues selon des techniques de circuits imprimés, ou similaires.

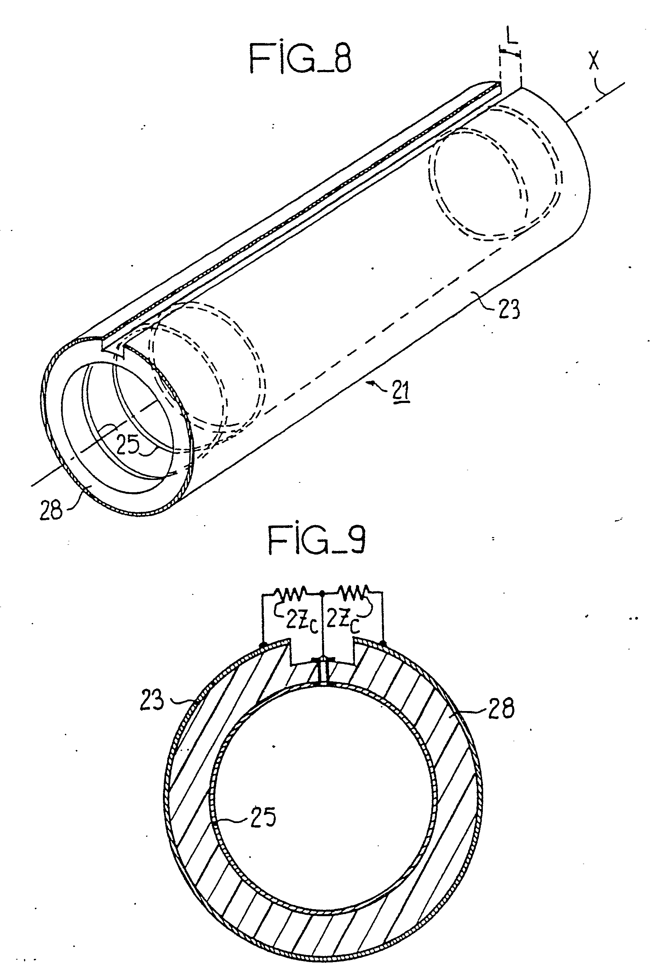

Les Figs. 6 et 7 se rapportent à des réalisations avec une ligne en ruban (dite strip-line en anglo-saxon) portée par un support isolant souple ou rigide. La bobine contient ou non un noyau magnétique suivant la sensibilité et la réponse en fréquence désirée. A chaque spire le conducteur externe de la ligne (blindage) est interrompu. A chaque rupture d'impédance correspondante, la ligne est adaptée par une ou plusieurs impédances dont la valeur équivalente est égale à l'impédance caractéristique de la ligne. Ces impédances peuvent être réalisées soit en éléments discrets, soit à l'aide d'une pâte résistive. Les parties dégagées de la ligne, suite à l'interruption du blindage, ainsi que les impédances rapportées peuvent faire l'objet également d'un blindage pour accroître la réjection du champ électrique.

La Fig. 6 représente un dispositif réalisé à partir d'un circuit imprimé souple enroulé 11.

Ce circuit double face comporte, sur une face le plan de masse 13 correspondant au blindage de la ligne et, sur l'autre, une série de pistes parallèles 15 formant avec le plan de masse les différents segments de ligne à ruban (strip-line).

Les résistances d'adaptation R11, R12, etc ... sont placées aux extrémités des pistes, les liaisons avec le plan de masse étant réalisées avec des trous métallisés, tel que 12. Après câblage de ces résistances, on enroule le circuit montré en partie à plat sur la Fig. 7 pour obtenir la disposition de la Fig. 6, c'est-à-dire un cylindre mais en ménageant un espace L entre les bords venant en vis à vis. Des moyens de maintien non figurés sont prévus (colliers d'extrémité, mandrin, etc ...). La continuité de la ligne est assurée en reliant par des bouts de conducteurs 19 les extrémités des spires 15 les unes aux autres pour former une hélice continue. Le plan de masse 13 qui se trouve à l'extérieur, reste ainsi interrompu pour éviter de créer une spire en court-circuit. La réjection du champ électrique est améliorée par un écran situé au dessus de la fente et raccordée à la masse par une liaison appropriée.

La Fig. 8 représente un dispositif capteur réalisé à partir d'un tube cylindrique rigide 28 en matériau diélectrique. Ce tube est initialement métallisé par un dépôt sur sa surface extérieure ainsi que sur sa surface intérieure. Le revêtement métallique extérieur va constituer le blindage 23 de la ligne à ruban. L'interruption de ce blindage pour ménager les différentes portions de largeur L est obtenu par usinage (fraisage, abrasion, gravure chimique, etc ...). Le dépôt interne forme le ruban 25 après usinage, tel un fraisage hélicoïdal qui enlève les parties métalliques inutiles.

La Fig. 9 de détail montre sur une coupe transversale le montage de résistances d'adaptation. Ces éléments situés à chaque spire à l'endroit de la fente correspondant aux portions démunies de blindage sont raccordées au ruban hélicoïdal 25 par une série de trous métallisés 22 situés à l'emplacement de la fente. Les résistances d'adaptation peuvent être soit des résistances discrètes entre les trous métallisés et le blindage, soit un dépôt de pâte résistive ajusté pas sablage, laser, etc ...

Un écran placé au dessus de la fente et relié à la masse par une liaison appropriée améliore la réjection du champ électrique.

**Revendications**

1. Dispositif capteur de champ magnétique utilisant une ligne d'impédance caractéristique constante (1), en structure coaxiale, comportant une spire démunie de son conducteur externe (3) sur une portion de la ligne, et avec des premiers moyens d'adaptation à ladite impédance caractéristique (Zc) prévus aux extrémités de sortie de la ligne destinées à être raccordées à un appareil de mesure (4) du courant induit, le dispositif capteur étant caractérisé par le fait que la ligne se compose d'une pluralité de spires formant un bobinage dont chaque spire comporte également une portion démunie du conducteur extérieur (3) et chacune de ces portions étant dotée de second moyens d'adaptation (R1, R2 . . .) pour compenser la rupture d'adaptation créée par ces interruptions de ligne coaxiale.

2. Dispositif capteur selon la revendication 1, caractérisé en ce que les portions démunies du conducteur extérieur sont régulièrement situées le long de la ligne à des écartements correspondant à la longueur d'une spire, le bobinage formant une hélice régulière autour d'un cylindre droit et les portions démunies du conducteur extérieur étant alignées parallèlement à l'axe (X) du cylindre.

3. Dispositif capteur selon la revendication 1 ou 2, caractérisé en ce que les second moyens d'adaptation sont des éléments résistifs discrets rapportés (R1,R2), ou intégrés (R3,R4).

4. Dispositif capteur selon l'une quelconque des revendications 1 à 3, caractérisé en ce que le bobinage entoure un noyau magnétique (2).

5. Dispositif capteur selon l'une quelconque des revendications 1 à 4, caractérisé en ce que des moyens de blindage sont prévus à l'endroit des portions démunies du conducteur extérieur afin d'accroître la réjection du champ électrique.

6. Dispositif capteur selon la revendication 5, caractérisé en ce que le blindage est formé par un manchon (6) qui entoure la ligne (1) en câble coaxial à l'endroit de chaque portion démunie du conducteur extérieur et que les manchons sont raccordés à la masse par un écran métallique constituant un conducteur à faible impédance et qui permet de relier ces manchons au conducteur extérieur en des points (B,C) diamètralement opposés de ceux (A) de liaison au manchon.

7. Dispositif capteur selon l'une quelconque des revendications 1 à 5, caractérisé en ce que la ligne d'impédance caractéristique constante est formée à partir d'un câble coaxial (1).

8. Dispositif capteur selon l'une quelconque des revendications 1 à 5, caractérisé en ce que la ligne d'impédance caractéristique constante est une ligne à ruban formée à partir d'un circuit imprimé souple (11) double face, enroulé avec la gravure des spires (15) interne et le plan de masse (13) externe, un espace (L) étant ménagé entre les bords en vis à vis avec des éléments de conducteurs (19) assurant la continuité des spires dans cet espace.

9. Dispositif capteur selon l'une quelconque des revendications 1 à 5, caractérisé en ce que la ligne d'impédance caractéristique constante est une ligne à ruban formée à partir d'un tube cylindrique rigide en matériau diélectrique (28) métallisé extérieurement (23) pour constituer le conducteur extérieur et avec usinage d'une fente pour ménager les dites portions, les spires (25) étant obtenues par usinage d'une métallisation interne.

10. Utilisation d'un dispositif capteur selon l'une quelconque des revendications précédentes, pour réaliser un appareil de mesure de champ magnétique alternatif, caractérisée en ce qu'elle englobe le capteur et l'appareil de mesure de courant (4) branché entre les bornes de sortie de la ligne d'impédance caractéristique constante (1, 11, 21).

**Patentansprüche**

1. Magnetfeld-Meßvorrichtung unter Verwendung einer Leitung (1) von konstanter Kennimpedanz in Koaxialstruktur, mit einer Windung, die von ihrem Außenleiter (3) über einen Teil der Leitung entblößt ist, und mit ersten Mitteln (Zc) zur Anpassung an die genannte Kennimpedanz, welche an den Ausgangsenden der Leitung vorgesehen sind, die dazu bestimmt sind, an ein Gerät (4) zur Messung des induzierten Stromes angeschlossen zu werden, wobei die Meßvorrichtung dadurch gekennzeichnet ist, daß die Leitung zusammengesetzt ist aus mehreren Windungen, die eine Wicklung bilden, wovon jede Windung ferner einen von dem Außenleiter (3) entblößten Teil umfaßt, und wobei jeder dieser Teile mit zweiten Anpassungsmitteln (R1, R2 . . .) versehen ist, um die Fehlanpassung zu kompensieren, welche durch diese Unterbrechungen der Koaxialleitung verursacht wird.

2. Meßvorrichtung nach Anspruch 1, dadurch gekennzeichnet, daß die von dem Außenleiter entblößten Teile regelmäßig entlang der Leitung in Abständen liegen, welche der Länge einer Windung entsprechen, wobei die Wicklung eine gleichmäßige Helix um einen aufrechten Zylinder herum bildet und die von dem Außenleiter entblößten Teile parallel zur Achse (X) des Zylinders ausgerichtet sind.

3. Meßvorrichtung nach Anspruch 1 oder 2, dadurch gekennzeichnet, daß die zweiten Anpassungsmittel resistive diskrete angesetzte (R1, R2) oder integrierte (R3, R4) Elemente sind.

4. Meßvorrichtung nach einem der Ansprüche 1 bis 3, dadurch gekennzeichnet, daß die Wicklung einen magnetischen Kern (2) umgibt.

5. Meßvorrichtung nach einem der Ansprüche 1 bis 4, dadurch gekennzeichnet, daß Abschirmmittel an den Stellen der von dem Außenleiter entblößten Teile vorgesehen sind, um die Unterdrückung des elektrischen Feldes zu verbessern.

6. Meßvorrichtung nach Anspruch 5, dadurch gekennzeichnet, daß die Abschirmung durch eine Hülse (6) gebildet ist, welche die Leitung (1) als Koaxialkabel an den Stellen jedes von dem Außenleiter entblößten Teiles umgibt, und daß die Hülsen mit Masse verbunden sind über einen Metallschirm, welcher einen Leiter von geringer Impedanz bildet und die Verbindung dieser Hülsen mit dem Außenleiter an Punkten (B, C) gestattet, welche diametral denen (A) der Verbindung mit der Hülse gegenüberliegen.

7. Meßvorrichtung nach einem der Ansprüche 1 bis 5, dadurch gekennzeichnet, daß die Leitung von konstanter Kennimpedanz aus einem Koaxialkabel (1) gebildet ist.

8. Meßvorrichtung nach einem der Ansprüche 1 bis 5, dadurch gekennzeichnet, daß die Leitung von konstanter Kennimpedanz eine Streifenleitung ist, welche aus einer flexiblen doppelseitigen gedruckten Schaltung (11) gebildet ist, die mit den gravierten Windungen (15) auf der Innenseite und der Masseebene (13) auf der Außenseite aufgewickelt ist, wobei ein Raum (L) zwischen den Rändern verbleibt, welche den Leiterelementen (19) gegenüberliegen, die die Kontinuität der Windungen in diesem Raum gewährleisten.

9. Meßvorrichtung nach einem der Ansprüche 1 bis 5, dadurch gekennzeichnet, daß die Leitung von konstanter Kennimpedanz eine Streifenleitung ist, die aus einem starren zylindrischen Rohr aus dielektrischem Material (28) gebildet ist, welches außenseitig metallisiert ist (23), um den Außenleiter zu bilden, und mit einem eingearbeiteten Schlitz versehen ist, um die genannten Teile anzubringen, wobei die Windungen (25) durch Bearbeitung einer innenseitigen Metallisierung erhalten sind.

10. Verwendung einer Meßvorrichtung nach einem der vorstehenden Ansprüche zur Herstellung eines Gerätes zur Messung eines magnetischen Wechselfeldes, dadurch gekennzeichnet, daß sie die Meßvorrichtung und das Strom-Meßgerät (4) umfaßt, das zwischen die Ausgangsanschlüsse der Leitung (1, 11, 21) von konstanter Kennimpedanz geschaltet ist.

**Claims**

1. Magnetic field probe device using a line of constant characteristic impedance (1), having a coaxial structure and comprising a winding bared from its outer conductor (3) along a portion of the line, and having first means for adaptation to said characteristic impedance (Zc) provided at the output ends of the line intended to be connected to an apparatus (4) for the measurement of the induced current, the probe device being characterized by the fact that the line is composed of a plurality of windings forming a coil each winding of which also comprises a portion which is bared from its outer conductor (3), and each of these portions being provided with second adaptation means (R1, R2 . . .) to compensate for the adaptation rupture caused by these interruptions of the coaxial line.

2. Probe device according to claim 1, characterized in that the portions bared from the outer conductor are regularly located along the line at spacings corresponding to the length of a winding, the coil forming a regular helix about an upright cylinder, and the portions bared from their outer conductors being aligned in parallel to the axis (X) of the cylinder.

3. Probe device according to claim 1 or 2, characterized in that the second adaptation means are resistive discrete added (R1, R2) or integrated (R3, R4) elements.

4. Probe device according to any of claims 1 to 3, characterized in that the coil surrounds a magnetic core (2).

5. Probe device according to any of claims 1 to 4, characterized in that screening means are provided at the locations of the portions bared from their outer conductors in order to increase the rejection of the electric field.

6. Probe device according to claim 5, characterized in that the screening is formed by a sleeve (6) surrounding the line (1) in the manner of a coaxial cable at the location of each portion bared from its outer conductor, and in that the sleeves are connected to ground through a metallic screen forming a conductor of low impedance and permitting to connect these sleeves to the outer conductor at points (B, C) diametrically opposed to those (A) of connection to the sleeve.

7. Probe device according to any of claims 1 to 5, characterized in that the line of constant characteristic impedance is formed of a coaxial cable (1).

8. Probe device according to any of claims 1 to 5, characterized in that the line of constant characteristic impedance is a strip line formed of a flexible double sided printed circuit (11) wound up with the engraving of the windings (15) on the inside and the ground plane (13) on the outside, a space (L) being left between the edges facing conductor elements (19) ensuring the continuity of the windings within this space.

9. Probe device according to any of claims 1 to 5, characterized in that the line of constant characteristic impedance is a strip line formed of a rigid cylindrical tube of dielectric material (28) metallized externally (23) to form the outer conductor, and having a recessed groove to provide said portions, the windings (25) being obtained by machining of an internal metallization.

10. Use of a probe device according to any of the preceding claims to provide an apparatus for the measurement of an alternative magnetic field, characterized in that it encompasses the probe and the current measurement apparatus (4) connected between the output terminals of the line of constant characteristic impedance (1, 11, 21).

Fig.1

Fig.2

Fig.3

## FIG_1

L

$2Z_C$   $2Z_C$

2

X

3

5

4

1

$Z_C$

$Z_C$

## FIG_2

$R_1$   $R_2$

A   6

7

C

1

B

## FIG_3

8   $R_3$   $R_4$

3   5   3   1

FIG_4

5  6

R₅  1

7

FIG_5

5  R₆

1

7

FIG_6

L

19

X

13

15

11

18

FIG_7

R₁₁

13

R₁₂  12

15

18

## FIG_8

## FIG_9

$2Z_C$ $2Z_C$